# EUROPÄISCHE PATENTANMELDUNG

(11) **EP 1 378 940 A2**
(43) Veröffentlichungstag der Anmeldung: **07.01.2004**
(21) Anmeldenummer: 03405446.0
(22) Anmeldetag: 19.06.2003
(51) Int. Cl.: H01L 23/367, H01L 23/373

(54) **Kühlvorrichtung für Halbleiterbauelemente oder dergleichen Einrichtungen**

(30) Priorität: 01.07.2002 DE 10229532
(71) Anmelder: Alcan Technology & Management AG, 8212 Neuhausen am Rheinfall (CH)
(72) Erfinder: Bock, Uwe, 78224 Singen (DE); Bock, Stefan, 78224 Singen (DE)

(57) **Zusammenfassung**

Bei einer Kühlvorrichtung für Halbleiterbauelemente --od.dgl. Einrichtungen -- mit einem insbesondere auf dem Wege des Strangpressens hergestellten Kühlkörper, der in Abstand zueinander von einer Sockelplatte (22) aufragende Kühlrippen (50) aufweist, sind diese jeweils mit einem Kupplungssockel (52) in einer in die Oberfläche der Sockelplatte (22) eingebrachten Einsatznut (34) von diese seitlich begrenzenden First- oder Zwischenrippen (36) klemmend gehalten. Die Sockelplatte (22) des Kühlkörpers (20) ist unterseitig mit Rippen als Rast- oder Kupplungsorganen versehen und diese sind kraft- oder formschlüssig in Nuten als Gegenorgane einer Grundplatte gehalten; diese Nuten verlaufen zwischen Rippen (16) der Grundplatte (10), welch letztere aus einem Werkstoff --bevorzugt aus einem Kupferwerkstoff -- besteht, der einen wesentlich höheren Wärmeleitwert aufweist als der Werkstoff für den Kühlkörper. Die Sockelplatte (22) des Kühlkörpers (20) soll aus Reinaluminium oder eine Aluminiumlegierung geformt sein.

## Beschreibung

Die Erfindung betrifft eine Kühlvorrichtung für Halbleiterbauelemente od. dgl. Einrichtungen mit einem -- insbesondere auf dem Wege des Strangpressens hergestellten --Kühlkörper, der in Abstand zueinander von einer Sockelplatte aufragende Kühlrippen aufweist, die jeweils mit einem -- querschnittlich etwa rechteckigen -- Kupplungssockel in einer in die Oberfläche der Sockelplatte eingebrachten Einsatznut von diese seitlich begrenzenden Längsoder Zwischenrippen klemmend gehalten sind.

Kühlkörper dieser Art sind der DE 35 18 310 A1 zu entnehmen; nach deren Lehre werden stranggepreßte Vollprofile mit seitlichen Ausformungen als Kühlrippen in die Einsatznuten der gesondert erzeugten Sockelplatte formschlüssig eingesetzt. Die Nutwände der Einsatznut werden nach dem Einbringen der Kühlrippe durch ein -- zwischen zwei Kühlrippen einfahrbares -- keilartig ausgebildetes Werkzeug verformt, das dazu in eine Hilfsnut V-förmigen Querschnitts eingesetzt wird und teilweise den Werkstoff des Gehäusesockels in Parallelnuten der Kühlrippe drückt.

Die DE 25 02 472 A1 zeigt an einem Kühlkörper für Thyristoren sich konisch zum Nutengrund hin verjüngende Einsatznuten der Basisgehäuseplatte für die Kühlrippen. Diese werden mit Übermaß in die -- mit Längsnuten in den beiden Seitenwänden versehenen -- Einsatznuten eingepresst. Während in diesem Falle eine Mindestdicke der Rippe erforderlich ist, um die notwendigen Druckkräfte beim Fügeverfahren aufnehmen zu können, ist bei dem Verfahren nach DE 35 18 310 A1 nur ein formschlüssiger Verbund erreichbar. In beiden Fällen ist die einsetzbare Rippenzahl -- und damit die erreichbare Wärme abführende Oberfläche -- einerseits durch die erforderliche Mindestdicke der Kühlrippen sowie andererseits durch die notwendige Mindestbreite der Zwischennuten begrenzt.

Die wachsende Leistungsfähigkeit von Halbleiterbauteilen bedingt in zunehmendem Maße besondere Lösungen für das Abführen der entstehenden hohen Verlustwärme; konventionell stranggepresste Kühlkörper kammförmiger Querschnitte aus Aluminium oder dessen Legierungen sind schon lange nicht mehr in der Lage, die wärmetechnischen Forderungen zu erfüllen. Alle bekannt gewordenen Lösungen haben die Zielsetzung, die Kühlleistung des Systems durch größtmögliche Oberfläche auf kleinstem Raum zu erhöhen. Bei genauer Betrachtung muss man zu dem Ergebnis kommen, dass hier inzwischen ein pysikalischer Grenzbereich in der Form erreicht wird; die erreichbaren Rippenabstände sind so gering, dass die für die Wärmeabfuhr erforderliche Luftmenge infolge des zu kleinen Luftquerschnittes mehr oder weniger unterschritten wird.

Der Gesamtwärmewiderstand des Systems setzt sich zusammen aus dem äußeren Wärmewiderstand -- aus Oberfläche und Wärmeübergangszahl -- sowie dem inneren Wärmewiderstand des Kühlkörpers, welcher von der Geometrie der Sockelplatte und der Rippengeometrie sowie dem Wärmeleitwert des verwendeten Materials abhängt.

Bisherige Bestrebungen, den äußeren Wärmewiderstand bis an den Grenzbereich heran zu reduzieren, führen zu dem Ergebnis, dass das Verhältnis von innerem zu äußerem Wärmewiderstand mehr als 2 : 1 betragen kann. Besonders kritisch ist der relativ hohe Wärmewiderstand der Sockelplatte zu werten, der durch das zunehmend ungünstige Verhältnis von notwendiger Sockelplattenfläche des Kühlkörpers zur Grundfläche der Halbleiter hervorgerufen wird. Die ständig kleiner werdenden Halbleiter bei steigendem Leistungsvermögen führen zu einer ungünstigen Wärmeverteilung in der Sockelplatte.

In Kenntnis dieses Standes der Technik haben sich die Erfinder die Aufgabe gestellt, eine neue Kühlvorrichtung mit erhöhter Leistungsfähigkeit zu entwickeln, dank deren die entstehende Verlustwärme besser abgeführt werden kann.

Zur Lösung dieser Aufgabe führt die Lehre des unabhängigen Anspruches; die Unteransprüche geben günstige Weiterbildungen an. Zudem fallen in den Rahmen der Erfindung alle Kombinationen aus zumindest zwei der in der Beschreibung, der Zeichnung und/oder den Ansprüchen offenbarten Merkmale.

Erfindungsgemäß ist die Sockelplatte des Kühlkörpers unterseitig mit Rast- oder Kupplungsorganen versehen, und diese sind kraft- oder formschlüssig in Gegenorganen einer Grundplatte gehalten. Dazu hat es sich als günstig erwiesen, die Rast- oder Kupplungsorgane der Sockelplatte als parallele Feder- oder Bodenrippen zu gestalten und die Grundplatte mit Nuten als Gegenorgane zur Aufnahme der Feder- oder Bodenrippen zu versehen.

Nach einem weiteren Merkmal der Erfindung wird die Grundplatte aus einem Werkstoff geformt, der einen wesentlich höheren Wärmeleitwert aufweist als der Werkstoff für den Kühlkörper. Jener Grundplattenwerkstoff kann beispielsweise Kupfer oder eine Kupferlegierung sein. Hingegen besteht die Sockelplatte des Kühlkörpers aus einer Al-Legierung, bevorzugt aber aus Reinaluminium und ist deshalb verhältnismäßig weich. Beide Platten werden im übrigen auf dem Wege des Strangpressens geformt oder durch mechanische bzw. spanende Bearbeitung eines Halbzeuges.

Vorteilhafterweise wird der Querschnitt der Grundplatte so gewählt, dass sie mehrere nebeneinander verlaufende Kühlkörper aufzunehmen vermag - dies in Abhängigkeit vom Einsatzzweck.

Um den Zusammenbau der Kühlvorrichtung zu erleichtern, können die Nuten der Grundplatte einen zylindrischen bis trapezförmigen Querschnitt aufweisen, der Querschnitt der Feder- oder Bodenrippen kann zudem breiter sein als die Nutweite sowie die Höhe der Feder- oder Bodenrippen größer als die Tiefe der Nut. Auch wird aus gleichem Grunde vorgeschlagen, die Feder- oder Bodenrippen anzufasen bzw. aus den Flankenwänden der Feder- oder Bodenrippe Längswulste oder Radialrippen auszuformen. Letzteres kann durch Einbringen von Längsnuten in die Flankenwände erfolgen oder durch einen Stauchvorgang, bei dem diese Radialrippen entstehen, welche durch Randspalte voneinander getrennt sind.

Die Festlegung der beschriebenen Teile geschieht mittels eines Druckspachtels, für welche die Kopffläche der Bodenrippe -- und/oder von die Nuten der Grundplatte begrenzenden Rippen -- etwa in Querschnittsmitte eine Kerbung enthält.

Nach einem weiteren Merkmal der Erfindung weist die Sockelplatte mit seitlich angeformten Seitenrippen einen U-förmigen Querschnitt auf, welcher den Umriss des Kühlkörpers vorgibt. Diese Seitenrippen sind zur Oberflächenvergrößerung außenseitig mit parallelen Längsrippen versehen sowie jeweils an eine Kantenrippe der Sockelplatte angeformt.

Im Rahmen der Erfindung liegt zudem, die Feder- oder Bodenrippen mit den Nutwänden der Grundplatte durch Umformung mittels jenes Werkzeuges einem Kaltverschweißvorgang zu unterziehen. Gleiches geschieht auch mit den Kupplungssockeln von Kühlrippen einerseits sowie den Wandungen von Einsatznuten in der Sockelplatte.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in:
- Fig. 1:: die Frontansicht einer Seitenplatte mit mehreren -- Kühlrippen aufweisenden -- Kühlkörpern;
- Fig. 2:: die Grundplatte ohne Kühlkörper;
- Fig.3 :: die Frontansicht einer Zwischenplatte des Kühlkörpers mit zwei Seitenrippen;
- Fig. 4:: die Frontansicht einer Zwischenplatte ohne Seitenrippen;
- Fig. 5, 6:: jeweils einen vergrößerten Ausschnitt aus der Zwischenplatte in zwei verschiedenen Ausgestaltungen;
- Fig. 7:: einen geschnittenen und vergrößerten Ausschnitt aus Fig. 1.

Eine Grundplatte 10 aus Kupfer oder einer Kupferlegierung der Länge a von hier 200 mm und einer Gesamthöhe h von 20 mm ist an ihrer Oberfläche 12 mit in Abstand b von 3,6 mm parallelen Nuten 14 einer Breite e von 4 mm und einer Tiefe f von 4,7 mm versehen, deren Querschnitt zylindrisch bis leicht trapezförmig sein kann. Die beiden äußeren der von den Nuten 14 begrenzten Rippen 16 bilden mit den Seitenflächen 11 der Grundplatte 10 Schulterabsätze 18 der Breite b₁ von 3,2 mm.

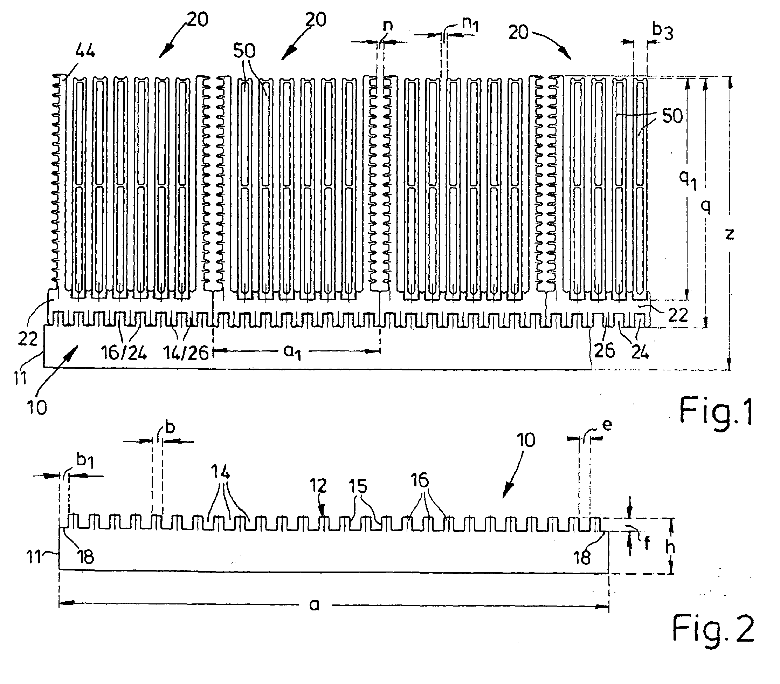

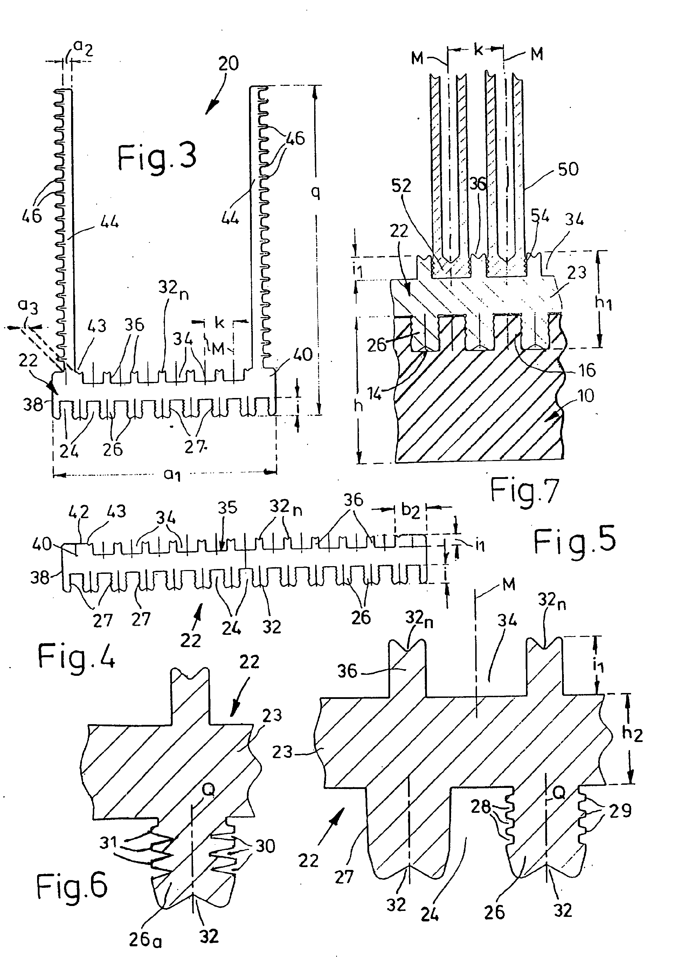

Auf der Grundplatte 10 sind in Fig. 1 mehrere Kühlkörper 20 für Halbleiterbauelemente festgelegt, deren jeder eine Sockel- oder Zwischenplatte 22 -- der Länge a₁ von etwa 61 mm und der Höhe h₁ von etwa 13,5 mm -- mit von beiden ihrer Oberflächen ausgehenden Nuten 24, 34 anbietet (Fig. 3). Die abwärts weisenden Bodennuten 24 der Tiefe i von 5 mm begrenzen zwischen sich Feder- oder Bodenrippen 26, in deren Flankenwände 27 Längsnuten 28 eingeformt sind; diese erzeugen -- wie Fig. 5 verdeutlicht -- seitliche Längswulste 29 als zahnartige Druckrippen für die gemäß Fig. 1, 7 eingesetzten Rippen 16 der Grundplatte 10. Eine andere Ausführung einer Bodenrippe 26ₐ deutet Fig. 6 an; diese Bodenrippe 26ₐ ist in Richtung ihrer Mittelachse Q gestaucht mit der Folge, dass ein ziehharmonikaähnliches Profil entsteht, dessen Radialrippen 31 durch Randspalte 30 getrennt sind.

Die Bodenrippen 26, 26ₐ bzw. -- zwischen Firstnuten 34 der Tiefe i₁ von 3,2 mm sowie eines Mittenabstandes k von 7,6 mm von deren Mittellinien M verlaufende -- First- oder Zwischenrippen 36 der Sockel- oder Zwischenplatte 22 sind mit einer querschnittlich schwalbenschwanzähnlich geformten Kopffläche 32 bzw. 32ₙ ausgestattet. Die Höhe h₂ des zwischen den Nuten 24, 34 verbleibenden querschnittlichen Plattenabschnitts 23 entspricht dem Maß der Tiefe i₁ der Firstnuten 34.

Zwischen den beiden äußeren Firstnuten 34 einerseits und den Seitenflächen 38 der Zwischenplatte 22 anderseits verläuft jeweils eine Kantenrippe 40 einer Breite b₂, die etwa jenem Mittenabstand k entspricht.

In Fig. 1, 3 ist der Kopffläche 42 der Kantenrippe 40 parallel zu den Mittellinien M der Firstnuten 34 eine Seitenrippe 44 so angeformt, dass ein innenseitig verbleibender Teil der Kopffläche 42 mit einer Längsnut 43 ausgestattet werden kann.

Die Höhe q der -- bevorzugt aus weichem Reinaluminium geformten -- Einheit aus Zwischenplatte 22 und Seitenrippe 44 -- und damit des Kühlkörpers 20 -- beträgt hier etwa 91 mm, ihre Firstbreite a₂ etwa 2,5 mm. An diese Seitenrippe 44 sind außenseitig Längsrippen 46 angeformt, und ihre Fußbreite a₃ mißt hier 3 mm, ist also etwas größer als jene Firstbreite a₂. In Fig. 1 beträgt der lichte Abstand n zwischen benachbarten Seitenrippen 44 zweier Kühlkörper 20 hier 2,6 mm.

In den als Einsatznuten dienenden Firstnuten 34 stecken in einem lichten Abstand n₁ zueinander parallel verlaufende -aus einer Aluminiumlegierung geformte -- Kühlrippen 50. Zwischenplatte 22 und Kühlrippen 50 werden getrennt auf dem Wege des Strangpressens hergestellt und anschließend zusammengefügt.

Die Kühlrippe 50 besteht aus einem - in Einbaulage frei aufragenden - Hohlprofil der Höhe q₁ von hier etwa 80 mm sowie der Breite b₃ von 5 mm. Der Querschnitt eines Kupplungssockels 52 entspricht gemäß Fig. 7 etwa jenem der First- oder Einsatznuten 34, die Sockelhöhe etwa der Nuttiefe i₁. Der Kupplungssockel 52 wird in die First- oder Einsatznut 34 der Zwischenplatte 22 eingeschoben, bis er dem Nutentiefsten 35 aufsitzt. Der besseren Lagesicherung zwischen den Nutwänden benachbarter Zwischen- oder Firstrippen 36 halber ist -- wie Fig. 7 zeigt -- jede Flankenfläche des Kupplungssockels 52 mit querschnittlich eine sägezahnartige Anordnung ergebenden Längsrippen 54 versehen, wie sie entsprechend zu den Flankenwänden 27 der Bodenrippen 26 der Fig. 5 beschrieben worden sind.

Nach dem Einsetzen des Kupplungssockels 52 der Kühlrippe 50 in die Einsatznut 34 wird auf die Oberfläche 32ₐ der Zwischen- oder Firstrippe 36 ein -- in der Zeichnung nicht dargestelltes -- spachtelähnliches Werkzeug aufgesetzt, dessen jener Oberfläche 32ₐ zugekehrter Bodenrand mit einer zinnenartigen Reihe von Zähnen ausgestattet sein kann. Durch Druck des Werkzeuges wird die Firstrippe 36 so verformt, dass sie dem Kupplungssockel 52 haltend anliegt.

Der mit den Kühlrippen 50 ausgestattete Kühlkörper 20 wird mit seiner Sockel- oder Zwischenplatte 22 so auf die Grundplatte 10 aufgesetzt, dass deren Nuten 14 die Boden oder Federrippen 26 der Zwischenplatte 22 aufnehmen; die mit den Firstrippen 36 ausgestattete Zwischenplatte 32 wird mit den leicht angefasten Federrippen 26 -- wie gesagt -- in die Nuten 14 der Grundplatte gesetzt und mit jenem spchatelförmigen Werkzeug drückend mit der Grundplatte 10 formschlüssig verbunden. Bei diesem Vorgang werden gleichzeitig die jene Kupplungssockel 52 umgreifenden kurzen Firstrippen 36 gestaucht, so dass gleichzeitig ein formschlüssiger Verbund zwischen Kupplungssockel 52 und Zwischenplatte 22 erreicht wird. Bei diesem Verformungsprozess wird sowohl zwischen dem Kupplungssockel 52 und den Firstrippen 36 als auch zwischen den Nutwänden 17 der Grundplatte 10 und den Federrippen 26 der Zwischenplatte 22 zumindest partiell eine Kaltpressschweißverbindung erzielt, welche einen guten Wärmeübergang bildet.

Auf diese Weise können mehrere Kühlkörper 20 zu einer Einheit -- einer beispielsweisen Höhe z von 106 mm -- verbunden werden.

## Patentansprüche

1. Kühlvorrichtung (20) für Halbleiterbauelemente od.dgl. Einrichtungen mit einem insbesondere auf dem Wege des Strangpressens hergestellten Kühlkörper (20), der in Abstand zueinander von einer Sockelplatte (22) aufragende Kühlrippen (50) aufweist, die jeweils mit einem Kupplungssockel (52) in einer in die Oberfläche der Sockelplatte (22) eingebrachten Einsatznut (34) von diese seitlich begrenzenden First- oder Zwischenrippen (36) klemmend gehalten sind,
**dadurch gekennzeichnet,**
**dass** die Sockelplatte (22) des Kühlkörpers (20) unterseitig mit Rast- oder Kupplungsorganen (26, 26ₐ) versehen ist und diese kraft- oder formschlüssig in Gegenorganen (14) einer Grundplatte (10) gehalten sind.

2. Kühlvorrichtung nach Anspruch 1, **dadurch gekennzeichnet, dass** die Grundplatte (10) aus einem Werkstoff besteht, der einen wesentlich höheren Wärmeleitwert aufweist als der Werkstoff für den Kühlkörper (20).

3. Kühlvorrichtung nach Anspruch 2, **gekennzeichnet durch** eine Grundplatte (10) aus einem Kupferwerkstoff.

4. Kühlvorrichtung nach Anspruch 1 oder 2, **dadurch gekennzeichnet, dass** die Sockelplatte (22) des Kühlkörpers (20) aus Reinaluminium oder eine Aluminiumlegierung geformt ist.

5. Kühlvorrichtung nach einem der Ansprüche 1 bis 3, **dadurch gekennzeichnet, dass** die Grundplatte (10) mehrere nebeneinander verlaufende Kühlkörper (20) aufnimmt.

6. Kühlvorrichtung nach einem der Ansprüche 1 bis 5, **dadurch gekennzeichnet, dass** die Rast- oder Kupplungsorgane der Sockelplatte (22) parallele Federoder Bodenrippen (26) sind und die Grundplatte (10) als Gegenorgane Nuten (14) zur Aufnahme der Feder- oder Bodenrippen aufweist.

7. Kühlvorrichtung nach Anspruch 6, **dadurch gekennzeichnet, dass** die Nuten (14) der Grundplatte (10) einen zylindrischen bis trapezförmigen Querschnitt aufweisen.

8. Kühlvorrichtung nach Anspruch 6 oder 7, **dadurch gekennzeichnet, dass** der Querschnitt der Feder- oder Bodenrippen (26, 26ₐ) breiter ist als die Nutweite (e).

9. Kühlvorrichtung nach einem der Ansprüche 6 bis 8, **dadurch gekennzeichnet, dass** die Höhe (i) der Feder- oder Bodenrippen (26, 26ₐ) größer ist als die Tiefe (f) der Nut (14).

10. Kühlvorrichtung nach wenigstens einem der Ansprüche 6 bis 9, **dadurch gekennzeichnet, dass** Feder- oder Bodenrippen (26, 26ₐ) angefast sind.

11. Kühlvorrichtung nach einem der Ansprüche 6 bis 10, **dadurch gekennzeichnet, dass** aus den Flankenwänden (27) der Feder- oder Bodenrippe (26) Längswulste (30) herausgeformt sind (Fig. 5).

12. Kühlvorrichtung nach einem der Ansprüche 6 bis 10, **dadurch gekennzeichnet, dass** die Feder- oder Bodenrippe (26ₐ) gestaucht sowie mit Radialrippen (31) versehen sind, die durch Randspalte (30) getrennt sind (Fig. 6).

13. Kühlvorrichtung nach einem der Ansprüche 6 bis 12, **dadurch gekennzeichnet, dass** die Kopffläche (32, 32ₐ) der Bodenrippe (26, 26ₐ) und/oder von die Nuten (14) der Grundplatte (10) begrenzenden Rippen (16) etwa in Querschnittsmitte eine Kerbung enthält/enthalten.

14. Kühlvorrichtung nach einem der Ansprüche 1 bis 13, **dadurch gekennzeichnet, dass** die Sockelplatte (22) mit seitlich angeformten Seitenrippen (44) einen U-förmigen Querschnitt aufweist (Fig. 3).

15. Kühlvorrichtung nach Anspruch 14, **dadurch gekennzeichnet, dass** die Seitenrippe (44) der Sockelplatte (22) außenseitig mit parallelen Längsrippen (46) versehen ist.

16. Kühlvorrichtung nach Anspruch 14 oder 15, **dadurch gekennzeichnet, dass** die Seitenrippe (44) an eine Kantenrippe (40) der Sockelplatte (22) angeformt ist.

17. Kühlvorrichtung nach einem der Ansprüche 1 bis 16, **dadurch gekennzeichnet, dass** in die Einsatznuten (34) der Sockelplatte (22) Kupplungssockel (52) von Kühlrippen (50) eingesetzt sind.

18. Kühlvorrichtung nach einem der Ansprüche 6 bis 17, **dadurch gekennzeichnet, dass** die Feder- oder Bodenrippen (26, 26ₐ) der Sockelplatte (22) mit den Nutwänden (15) der Grundplatte (10) und/oder die Kupplungssockel (52) mit den Firstrippen (36) der Zwischenplatten (22) kaltverschweißt sind.
